# EUROPEAN PATENT APPLICATION

(11) **EP 4 845 347 A1**
(43) Date of publication of application: **25.11.2026**
(21) Application number: 24829009.0
(22) Date of filing: 22.03.2024
(51) Int. Cl.: H10F 19/80, C09J 7/30, C09J 7/00

(54) **SOLAR CELL BUSBAR-FREE INTEGRATED FILM AND PREPARATION METHOD THEREFOR**

(30) Priority: 17.01.2024 CN 202410072094
(71) Applicant: Zhejiang Sinopoly Materials Co., Ltd., Jiaxing, Zhejiang 314031 (CN)
(72) Inventor: SHI, Hongtao, Jiaxing, Zhejiang 314031 (CN); JIAO, Hua, Jiaxing, Zhejiang 314031 (CN); CAI, Shuyi, Jiaxing, Zhejiang 314031 (CN)
(74) Representative: Cabinet Chaillot
(86) International application number: PCT/CN2024/083371
(87) International publication number: WO 2025/152264

(57) **Abstract**

The present invention discloses a zero-busbar integrated film for a solar cell. The integrated film includes a conventional adhesive film and a pretreated adhesive film, and a gram weight ratio of the pretreated adhesive film to the conventional adhesive film is (1-3):(3-1). According to the present invention, the pretreated adhesive film adopts a pre-crosslinking degree of 20-40%, and electron irradiation energy used is 10-20 kGy, such that the adhesive film with proper fluidity can be obtained without affecting the contact between a welding strip and a finger and without generating bad appearance of a module. Moreover, a gram weight proportion of the pretreated adhesive film in the zero-busbar integrated film is 40-70%, such that an electroluminescent image of a formed cell module is normal, and the cell module has no appearance defects. A skin film and a conventional photovoltaic adhesive film are replaced by utilizing an out-of-mold compounding technology in cooperation with processes such as dispensing or welding dispensing, thereby achieving a zero-busbar technology of solar cells.

## Description

### TECHNICAL FIELD

The present invention relates to a zero-busbar integrated film for a solar cell and a preparation method thereof, relates to H01L, and specifically relates to the fields of cell modules capable of converting light energy into electric energy.

### BACKGROUND

Reducing cost to increase benefit is one of main themes of the photovoltaic industry. Finger lines of traditional crystalline silicon cell sheets are connected by busbar lines, and the cell sheets are connected into cell strings on busbars by stitch welding with welding strips. According to a zero-busbar technology, fingers are directly connected by welding strips, thereby eliminating the busbars and achieving the purpose of reducing cost. Existing zero-busbar solar cells have three processing technologies: dispensing, welding dispensing, and Smartwire. The Smartwire process is complex and high in cost, and both the dispensing and welding dispensing processes have advantages and disadvantages. The present application develops an integrated adhesive film, which can replace existing skin films and conventional films by cooperating with the process of dispensing or welding dispensing, thereby optimizing the processing technologies of the zero-busbar solar cells, reducing technical indexes of precision of adhesive films, achieving a simpler process and increasing the processing speed.

Chinese Invention Patent CN202211492760.X discloses a segmented low-temperature welding strip, a zero-busbar IBC cell string, a cell module and an encapsulating method thereof. By integrating the segmented low-temperature welding strip with an insulating region, printing of an insulating region on a zero-busbar IBC cell sheet is removed, such that the problem of short circuit caused by the welding strip deviating from the insulating region during lamination can be effectively prevented. However, simplification of the processes is not improved significantly. Chinese Invention Patent CN202110133529.0 discloses a composite film for interconnecting zero-busbar heterojunction solar cell modules and a preparation method thereof. By using the hollowed-out composite film, the light transmittance after lamination can reach 90% or above, which improves the photoelectric conversion power of the cell modules. However, the composite film will affect the contact between a welding strip and a finger during the lamination, such that an electroluminescent image is poor.

### SUMMARY

In order to optimize the fluidity of zero-busbar integrated films to achieve excellent electroluminescent (EL) images of cell sheets and no defects, such as air bubbles and patterns, of the appearance of modules, a first aspect of the present invention provides a zero-busbar integrated film for a solar cell. The integrated film includes a conventional adhesive film and a pretreated adhesive film, and a gram weight ratio of the pretreated adhesive film to the conventional adhesive film is (1-3):(3-1).

As a preferred embodiment, raw materials for preparing the pretreated adhesive film include in parts by weight: 100 parts of a matrix resin, 0.5-2 parts of a crosslinking agent, and 0.1-2 parts of an auxiliary crosslinking agent.

As a preferred embodiment, the matrix resin is selected from a combination of one or more of an EVA (ethylene-vinyl acetate copolymer) matrix resin, a POE (polyvinyl octene coelastomer) matrix resin, and a PVB (polyvinyl butyral) matrix resin.

As a preferred embodiment, a specific gravity of the EVA matrix resin is 0.8-1.0 g/cm³, and a melting index at 190°C and 2.16 kg is 12-26 g/10 min; and a specific gravity of the POE matrix resin is 0.8-1.0 g/cm³, and a melting index at 190°C and 2.16 kg is 3-22 g/10 min.

As a preferred embodiment, the specific gravity of the EVA matrix resin is 0.952 g/cm³, and the melting index at 190°C and 2.16 kg is 25 g/10 min; and the specific gravity of the POE matrix resin is 0.8-0.9 g/cm³, and the melting index at 190°C and 2.16 kg is 4-14 g/10 min.

As a preferred embodiment, the crosslinking agent is a peroxide crosslinking agent, and the peroxide crosslinking agent is a tert-butyl peroxide crosslinking agent.

As a preferred embodiment, the tert-butyl peroxide crosslinking agent includes, but is not limited to, a combination of one or more of tert-butylperoxy 2-ethylhexyl carbonate and tert-amylperoxy 2-ethylhexyl carbonate.

As a preferred embodiment, the auxiliary crosslinking agent includes, but is not limited to, a combination of one or more of triallyl isocyanurate, 2,4,6-triallyloxy-1,3,5-triazine, and trimethylolpropane triacrylate.

As a preferred embodiment, a pre-crosslinking degree of the pretreated adhesive film is 10-50%, and crosslinking energy used for pretreatment of the pretreated adhesive film is 10-80 kGy.

As a preferred embodiment, the pre-crosslinking degree of the pretreated adhesive film is 20-40%, and the crosslinking energy used for pretreatment of the pretreated adhesive film is 10-20 kGy.

The applicant has found in an experimental process that by applying the prepared solar cell adhesive film to a zero-busbar process of solar cells in cooperation with a dispensing or welding dispensing process, processing technologies of the zero-busbar solar cells can be optimized, thereby reducing the problem of virtual connection of welding strips and fingers. The welding strips are connected to cell sheets by a dispensing or welding dispensing method and have gaps with the cell sheets. When the fluidity of the adhesive film is too high, the adhesive film will enter the gaps between the welding strips and the cell sheets after lamination, thereby affecting the contact between the welding strips and the fingers and resulting in black stripes in an electroluminescence test. When the fluidity of the adhesive film is too low, modules are likely to have poor appearance and have the problems of air bubbles and patterns after lamination. By controlling electron irradiation energy of the pretreated adhesive film, the pre-crosslinking degree of the pretreated adhesive film can be controlled, such that the adhesive film has relatively low fluidity. The integrated film obtained by compounding of the pretreated adhesive film and the conventional adhesive film can have suitable fluidity, which will neither affect the EL performance of the solar cell, nor cause bad appearance such as air bubbles and patterns.

As a preferred embodiment, a pretreatment method of the pretreated adhesive film is selected from a combination of one or more of corona discharge, electron irradiation, and ultraviolet irradiation.

As a preferred embodiment, a gram weight proportion of the pretreated adhesive film in the zero-busbar integrated film is 25-75%.

As a preferred embodiment, the gram weight proportion of the pretreated adhesive film in the zero-busbar integrated film is 40-70%.

As a preferred embodiment, when the pre-crosslinking degree of the pretreated adhesive film is 20-30%, the gram weight proportion of the pretreated adhesive film in the zero-busbar integrated film is 50-70%; and when the pre-crosslinking degree of the pretreated adhesive film is 30-40%, the gram weight proportion of the pretreated adhesive film in the zero-busbar integrated film is 40-50%.

The applicant has found in an experimental process that when the pre-crosslinking degree adopted is 20-40% and the gram weight proportion of the pretreated adhesive film in the integrated film is 40-70%, an electroluminescence image of a cell sheet formed by combination and proportioning is normal, and the cell sheet has no appearance defects.

A second aspect of the present invention provides a preparation method of a zero-busbar integrated film for a solar cell, which includes the following steps:
S1, compounding a pretreated adhesive film and a conventional adhesive film by utilizing an out-of-mold compounding technology; and
S2, compounding a pretreated adhesive film surface with a cell sheet, and compounding a conventional adhesive film surface with a solar backsheet or glass to obtain a cell module.

As a preferred embodiment, technical parameters of the out-of-mold compounding technology are as follows: a temperature of a mold is 80-100°C; a temperature of an adhesive roller is 0-50°C; a temperature of a steel roller is 0-50°C; and a traction speed is 5-20 m/min.

As a preferred embodiment, the pretreated adhesive film is loaded in contact with the adhesive roller in step 1, and the conventional adhesive film is loaded in contact with the steel roller after being extruded out from the mold.

The applicant has found in an experimental process that by controlling the processing technical parameters of the pretreated adhesive film and the conventional adhesive film, the overall compounding performance of the integrated film can be optimized, avoiding delamination of the integrated film. It is speculated that possible reasons are as follows: since the pretreated adhesive film adopts the optimized pre-crosslinking degree, good bonding performance between the pretreated adhesive film and the conventional adhesive film can be maintained, and at the optimal temperature and traction speed, the pretreated adhesive film and the conventional adhesive film have certain flexibility, can be closely fitted, have a good bonding effect and are difficult to delaminate.

As a preferred embodiment, the zero-busbar integrated film for a solar cell is applied to cell modules containing welding strips and grid lines, including but not limited to, heterojunctions, TOPCon, Perc, etc.

Compared with the prior art, the present invention has the following beneficial effects.
(1) According to the zero-busbar integrated film for a solar cell of the present invention, the pretreated adhesive film adopts the pre-crosslinking degree of 20-40%, and the electron irradiation energy used is 10-20 kGy, such that the adhesive film with proper fluidity can be obtained without affecting the contact between a welding strip and a finger and without generating bad appearance of a module.
(2) According to the zero-busbar integrated film for a solar cell of the present invention, the pretreated adhesive film adopts the pre-crosslinking degree of 20-40%, and the gram weight proportion of the pretreated adhesive film in the zero-busbar integrated film is 40-70%, such that an electroluminescent image of a formed cell sheet is normal, and a cell module has no appearance defects.
(3) According to the zero-busbar integrated film for a solar cell of the present invention, by adopting the out-of-mold compounding technology at the mold temperature of 80-100°C, the adhesive roller temperature of 0-50°C, the steel roller temperature of 0-50°C and the traction speed of 5-20 m/min, the formed integrated adhesive film is uniform in thickness, and the pretreated adhesive film and the conventional adhesive film have good compounding bonding capability and are difficult to delaminate.
(4) The zero-busbar integrated film for a solar cell of the present invention can be applied to a variety of solar cell modules containing resin material adhesive films and has a wide range of application fields.
(5) According to the zero-busbar integrated film for a solar cell of the present invention, a skin film and a conventional photovoltaic adhesive film are replaced by utilizing the out-of-mold compounding technology in cooperation with processes such as dispensing or welding dispensing, thereby achieving a zero-busbar technology of solar cells and achieving good EL and appearance performance of solar cell modules.

### BRIEF DESCRIPTION OF THE DRAWINGS

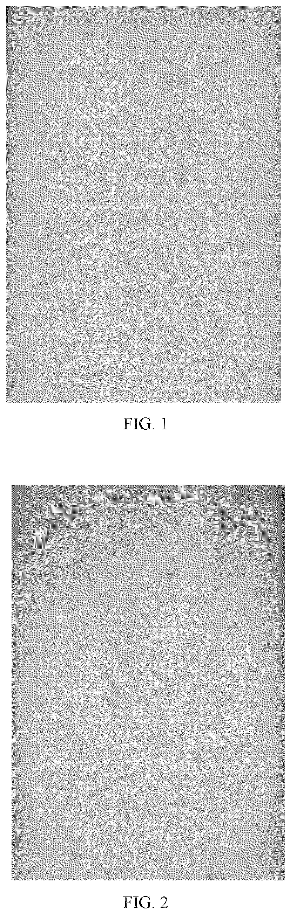

FIG. 1 is an EL image of a solar cell sheet prepared from a zero-busbar integrated film for a solar cell that is prepared and detected as Grade A in an example.
FIG. 2 is an EL image of a solar cell sheet prepared from a zero-busbar integrated film for a solar cell that is prepared and detected as Grade B in an example.
FIG. 3 shows local images of appearance defects at different positions of a solar cell module prepared from a zero-busbar integrated film for a solar cell that is prepared and detected as Grade C in an example.
FIG. 4 is a schematic diagram of an out-of-mold compounding device;

In the figures: 1, mold; 2, steel roller; 3, adhesive roller; 4, conventional adhesive film; 5, pretreated adhesive film.

### DESCRIPTION OF THE EMBODIMENTS

### Examples

A zero-busbar integrated film for a solar cell is provided. The zero-busbar integrated film includes a conventional adhesive film 4 and a pretreated adhesive film 5. Raw materials for preparing the pretreated adhesive film 5 include in parts by weight: 100 parts of a matrix resin, 1.3 parts of a crosslinking agent, and 1 part of an auxiliary crosslinking agent.

The matrix resin is an EVA resin having a specific gravity of 0.952 g/cm³ and a melting index of 25 g/10 min at 190°C and 2.16 kg, which is purchased from Sailboat and has a model of V2825.

The crosslinking agent is tert-butylperoxy 2-ethylhexyl carbonate, and the auxiliary crosslinking agent is trimethylolpropane triacrylate.

Crosslinking energy used for pretreatment of the pretreated adhesive film 5 is 15±5 kGy.

A pretreatment method of the pretreated adhesive film 5 is electron irradiation.

The conventional adhesive film 4 is an EVA adhesive film. Raw materials for preparing the conventional adhesive film are the same as the pretreated adhesive film. The conventional adhesive film is kept in an extruder at 80°C for 2 min and then extruded out by a die of a mold.

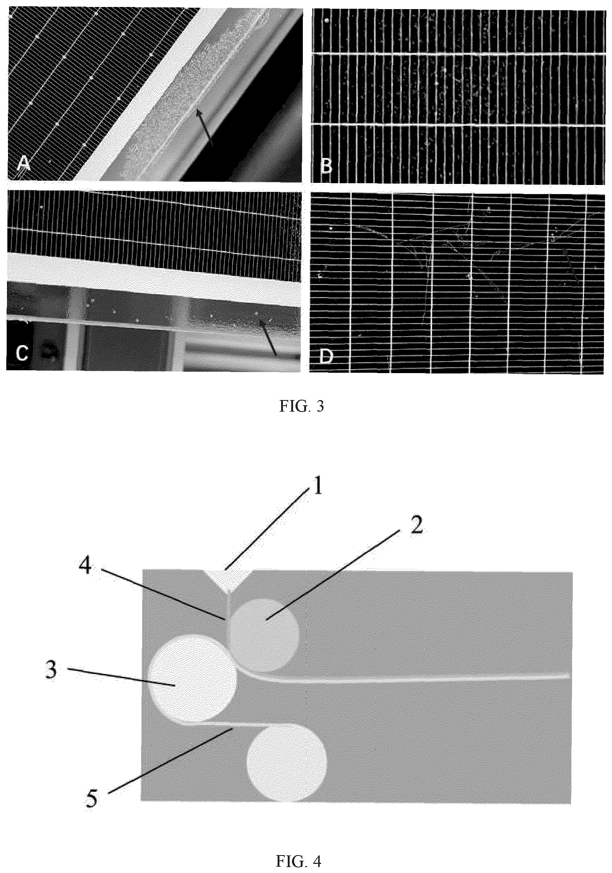

An out-of-mold compounding device is shown in FIG. 4. A preparation method of a zero-busbar integrated film for a solar cell includes the following steps:
S1, loading a pretreated adhesive film 5 in contact with an adhesive roller 3 by utilizing an out-of-mold compounding technology, loading a conventional adhesive film 4 in contact with a steel roller 2 after being extruded out from a mold, and compounding the pretreated adhesive film 5 and the conventional adhesive film 4 by co-extrusion; and
S2, compounding a pretreated adhesive film surface 5 with a cell sheet, and compounding a conventional adhesive film surface 4 with a solar backsheet or glass to obtain a cell module.

Technical parameters of the out-of-mold compounding technology are as follows: a temperature of the mold 1 is 90°C; a temperature of the adhesive roller 3 is 45°C; a temperature of the steel roller 2 is 45°C; and a traction speed is 10 m/min.

The pre-crosslinking degree and gram weight proportion of the pretreated adhesive film are shown in Tables 1-3.

**Table 1**

| a (gram weight of the pretreated adhesive film is 100 g/m²) | | Overall gram weight of the integrated film (g/m²) | | |
|---|---|---|---|---|
| | | 400 | 450 | 500 |
| Pre-crosslinking degree of the pretreated adhesive film/% | 10 | Example 1 | Example 2 | Example 3 |
| | 20 | Example 4 | Example 5 | Example 6 |
| | 30 | Example 7 | Example 8 | Example 9 |
| | 40 | Example 10 | Example 11 | Example 12 |
| | 50 | Example 31 | Example 32 | Example 13 |

**Table 2**

| b (gram weight of the pretreated adhesive film is 200 g/m²) | | Overall gram weight of the integrated film (g/m²) | | |
|---|---|---|---|---|
| | | 400 | 450 | 500 |
| Pre-crosslinking degree of the pretreated adhesive film/% | 10 | Example 14 | Example 15 | Example 16 |
| | 20 | Example 24 | Example 17 | Example 18 |
| | 30 | Example 25 | Example 26 | Example 19 |
| | 40 | Example 33 | Example 27 | Example 28 |
| | 50 | Example 34 | Example 35 | Example 36 |

**Table 3**

| c (gram weight of the pretreated adhesive film is 300 g/m²) | | Overall gram weight of the integrated film (g/m²) | | |
|---|---|---|---|---|
| | | 400 | 450 | 500 |
| Pre-crosslinking degree of the pretreated adhesive film/% | 10 | Example 20 | Example 21 | Example 22 |
| | 20 | Example 37 | Example 29 | Example 23 |
| | 30 | Example 38 | Example 39 | Example 30 |
| | 40 | Example 40 | Example 41 | Example 42 |
| | 50 | Example 43 | Example 44 | Example 45 |

As detected, cell modules prepared in Examples 1-23 are at Grade B in performance tests, cell modules prepared in Examples 24-30 are at Grade A in performance tests, and cell modules prepared in Examples 31-45 are at Grade C in performance tests.

### Performance tests

1. EL image test: EL images of the cell modules prepared in Examples 1-45 were tested.
2. Cell module appearance: The appearance of the cell modules prepared in Examples 1-45 was observed.

Test results are shown in Table 4.

**Table 4**

| | EL image | Appearance |
|---|---|---|
| Grade A | Normal (see FIG. 1) | No defects |
| Grade B | Black stripe defects (see FIG. 2) | No defects |
| Grade C | Normal | Adhesive film having an edge that is not completely melted (upper left of FIG. 3); small air bubbles/fogging (upper right of FIG. 3); air bubbles at an edge (lower left of FIG. 3); and patterns (lower right of FIG. 3) |

## Claims

1. A zero-busbar integrated film for a solar cell, **characterized in that** the integrated film comprises a conventional adhesive film and a pretreated adhesive film, and a gram weight ratio of the pretreated adhesive film to the conventional adhesive film is (1-3):(3-1).

2. The zero-busbar integrated film for a solar cell according to claim 1, **characterized in that** raw materials for preparing the pretreated adhesive film comprise in parts by weight: 100 parts of a matrix resin, 0.5-2 parts of a crosslinking agent, and 0.1-2 parts of an auxiliary crosslinking agent.

3. The zero-busbar integrated film for a solar cell according to claim 2, **characterized in that** the matrix resin is selected from a combination of one or more of an EVA matrix resin, a POE matrix resin, and a PVB matrix resin.

4. The zero-busbar integrated film for a solar cell according to claim 3, **characterized in that** a specific gravity of the EVA matrix resin is 0.8-1.0 g/cm³, and a melting index at 190°C and 2.16 kg is 12-26 g/10 min; and a specific gravity of the POE matrix resin is 0.8-1.0 g/cm³, and a melting index at 190°C and 2.16 kg is 3-22 g/10 min.

5. The zero-busbar integrated film for a solar cell according to claim 2, **characterized in that** the crosslinking agent is a peroxide crosslinking agent, and the peroxide crosslinking agent is a tert-butyl peroxide crosslinking agent.

6. The zero-busbar integrated film for a solar cell according to claim 1, **characterized in that** a pre-crosslinking degree of the pretreated adhesive film is 10-50%.

7. The zero-busbar integrated film for a solar cell according to claim 6, **characterized in that** a pretreatment method of the pretreated adhesive film is selected from a combination of one or more of corona discharge, electron irradiation, and ultraviolet irradiation; and crosslinking energy used for electron irradiation pretreatment of the pretreated adhesive film is 10-80 kGy.

8. The zero-busbar integrated film for a solar cell according to claim 1, **characterized in that** a gram weight proportion of the pretreated adhesive film in the zero-busbar integrated film is 25-75%.

9. A preparation method of the zero-busbar integrated film for a solar cell according to any one of claims 1-8, comprising the following steps:
S1, compounding the pretreated adhesive film and the conventional adhesive film by utilizing an out-of-mold compounding technology; and
S2, compounding a pretreated adhesive film surface with a cell sheet, and compounding a conventional adhesive film surface with a solar backsheet or glass to obtain a cell module.

10. The preparation method of the zero-busbar integrated film for a solar cell according to 9, **characterized in that** technical parameters of the out-of-mold compounding technology are as follows: a temperature of a mold is 80-100°C; a temperature of an adhesive roller is 0-50°C; a temperature of a steel roller is 0-50°C; and a traction speed is 5-20 m/min.
